# EUROPEAN PATENT SPECIFICATION

(11) **EP 2 940 782 B1**
(45) Date of publication and mention of the grant of the patent: **03.06.2020**
(21) Application number: 15164954.8
(22) Date of filing: 24.04.2015
(51) Int. Cl.: H01P 1/15

(54) **SEMICONDUCTOR DIODE SWITCH**
HALBLEITERDIODENSCHALTER
COMMUTATEUR À DIODE À SEMI-CONDUCTEUR

(30) Priority: 29.04.2014 FI 20145395
(43) Date of publication of application: 04.11.2015
(73) Proprietor: Bittium Wireless Oy, 90590 Oulu (FI)
(72) Inventor: Purkunen, Esa, 90590 Oulu (FI)
(74) Representative: Kolster Oy Ab

(56) References cited:
- EP-A1- 1 427 115
- JP-A- 2011 234 110
- US-A1- 2005 093 646
- US-A1- 2010 097 119
- BOB Y MA ET AL: "High power AlGaN/GaN Ku-band MMIC SPDT switch and design consideration", MICROWAVE SYMPOSIUM DIGEST, 2008 IEEE MTT-S INTERNATIONAL, IEEE, PISCATAWAY, NJ, USA, 15 June 2008 (2008-06-15), pages 1473-1476, XP031441328, ISBN: 978-1-4244-1780-3

## Description

### FIELD

The invention relates to a semiconductor diode switch and a method of its use.

### BACKGROUND

In many cases there is a need to connect and disconnect signals to or from an antenna in the radio frequency (RF) and microwave product field. PIN diodes can be used in such cases as switch components. The purpose of the diode switch is usually to provide a selective one- or bi-directional RF signal path. Patent document US 20100097119 presents a gallium nitride switch methodology. Patent document US 20050093646 presents a high frequency switch. Document BOB Y MA ET AL: "High power AIGaN/GaN Kuband MMIC SPDT switch and design consideration", MICROWAVE SYMPOSIUM DIGEST, 2008 IEEE MTT-S INTERNATIONAL, IEEE, PISCATAWAY, NJ, USA, 15 June 2008 (2008-06-15), pages 1473-1476, XP031441328, ISBN: 978-1 -4244-1780-3, presents a single pole double throw switch. Patent document JP 2011234110 presents a high frequency circuit having functions of a variable attenuator and a high frequency switch in a single circuit.

The PIN diode switches are designed for single pole - single throw (SPST) or single pole - dual throw (SPDT) purposes. The dual throw diode switches have usually different insertion losses in different signal paths. By combining dual throw switches in order to realize a multi throw diode switch, the insertion loss difference is multiplied which results in severe imbalance between the selected signal paths. Additionally, the relay combinations of diode switches are unreliable, expensive and many original equipment manufacturers and operators don't accept the usage of relays. Furthermore, the relay structure results in large physical volume. Thus, there is a need for improvement.

### BRIEF DESCRIPTION

An object of the present invention is to provide an improved diode switch and an improved method thereto. The objects of the invention are achieved by a semiconductor diode switch of the independent claim 1.

According to another aspect of the present invention, there is provided an independent switching method claim 7 for a semiconductor diode switch.

The preferred embodiments of the invention are disclosed in the dependent claims.

The invention provides advantages. Insertion losses and the standing wave ratio (SWR) can be made low while increasing reliability and decreasing need of the size.

### LIST OF THE DRAWINGS

In the following the invention will be described in greater detail by means of preferred embodiments with reference to the attached drawings, in which
Figures 1A illustrates an example of a path with diode switch circuits in shunt with the signal paths, the diode switch circuits having balanced impedance;
Figures 1B illustrates another example of a path with diode switch circuits in shunt with the signal paths, the diode switch circuits having balanced impedance;
Figure 2 illustrates an example of a signal path with a first diode switch circuit in series with the transmission lines;
Figure 3 illustrates an example of a signal path with diode switch circuits having diodes in series with the signal path and a termination with a shunt diode;
Figure 4 illustrates an example of SPMT diode switch; and
Figure 5 illustrates an example of a flow chart of a method for the diode switch.

### DESCRIPTION OF EMBODIMENTS

The following embodiments are only examples. Although the specification may refer to "an" embodiment in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may contain also features/structures that have not been specifically mentioned.

It should be noted that while Figures illustrate various embodiments, they are simplified diagrams that only show some structures and/or functional entities. The connections shown in these Figures may refer to logical or physical connections. Interfaces between the various elements may be implemented with suitable interface technologies. It is apparent to a person skilled in the art that the described apparatuses may also comprise other functions and structures. Therefore, they need not be discussed in more detail here. Although separate single entities have been depicted, different parts may be implemented in one or more physical or logical entities.

Diode switches may be used to switch frequencies in a range from about 100 MHz to 20 GHz without restricting these values. The terms "common pole" and "throw pole" refer to switch contact ports. The number of throws poles is the number of separate switch positions which the switch can make a contact to or cut the contact from.

When it is question of a switch of antenna beam selection, a purpose is usually to achieve the lowest insertion loss possible, without ruining the efficiency of the diode switch. Another purpose is to have a diode switch that is in general reasonable in dimensions/size and weight. Also the highest possible isolation to other signal paths and a good termination of the signal paths, which are selected not to allow the transfer of the signal, is also required. A part of or all this may be achieved with the diode switch described below.

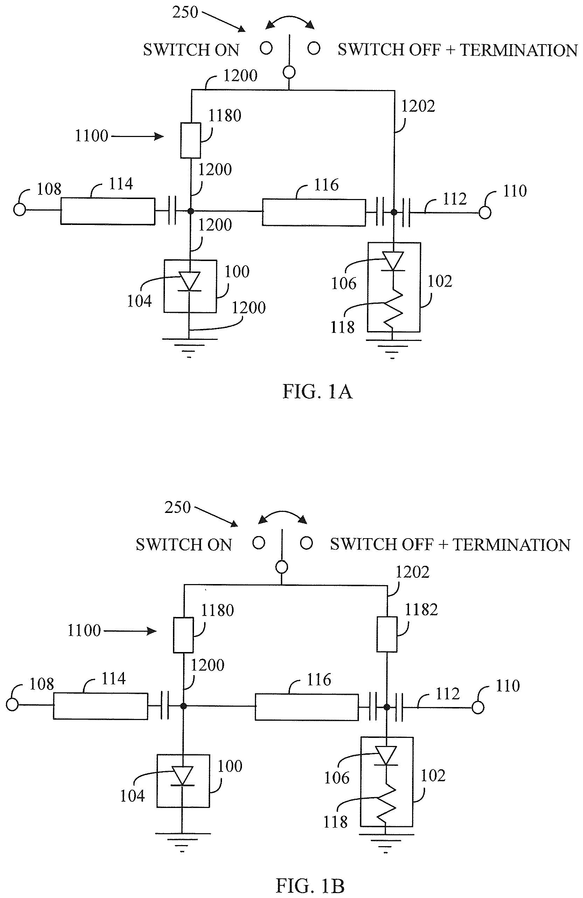

Figure 1A shows an example of a diode switch comprising one common pole 108, one throw pole 110 and a signal path 112 therebetween. The example can be understood to show one path of a multipath switch. The path 112 comprises a first diode switch circuit 100 and a second diode switch circuit 102. The diode circuits 100, 102 may comprise semiconductor diodes 104, 106. The semiconductor diodes 104, 106 may be PIN (Positive-Intrinsic-Negative) diodes, for example. The diodes 104, 106 may allow or block a signal transfer along the path 112 between the common pole 108 and the throw pole 110, where the mode to allow or to block depends on whether the diodes 104, 106 are forward biased or reverse biased. When a diode 104, 106 is forward biased, it conducts electricity and passes a signal through. When a diode 104, 106 is reverse biased, it doesn't conduct electricity and doesn't pass a signal through.

The signal transferred between the common pole 108 and the throw pole 100 may be an RF (Radio Frequency) signal or a microwave signal. Although Figures show only one diode 104, the diode 104 may be replaced by a plurality of diodes all of which are coupled in the same operational direction with respect to biasing, the diodes being in a series or parallel coupling. Similarly, the diode 106 may be replaced by a plurality of diodes coupled in the same operational direction with respect to biasing, the diodes being in a series or parallel coupling.

The signal path 112 additionally comprises a first quarter wave transmission line 114 between the common pole 108 and the first diode switch circuit 100, and a second quarter wave transmission line 116 between the first diode switch circuit 100 and the second diode switch circuit 102.

When the at least one diode 104 in Figure 1A is forward biased, no electric signal can be transferred in the signal path 112 between the common pole 108 and the throw pole 110. When the at least one diode 104 is reverse biased, signal transfer may take place between the common pole 108 and the throw pole 110. The at least one diode 106 may cause a similar effect on the basis of its biasing. The at least one diode 106 is used to terminate the signal path 112 at the end of the second quarter wave transmission line 116 with a terminating resistor 118. The terminating resistor 118 may comprise one or more resistor and/or impedance components.

The quarter wave transmission line 114, 116 may comprise a coaxial line such as a coaxial cable, a strip of metal such as a stripline or microstrip, for example.

In the diode switch coupling of Figure 1A, when the at least one diode 104 is forward biased, the quarter wave transmission line 114 is short circuited to the ground. Such a coupling is seen as open circuit by the common pole 108 and a signal transmitted by the common pole 108 cannot propagate to the throw pole 110. Correspondingly, when the at least one diode 104 is reverse biased, the quarter wave transmission line 114 is not short circuited to the ground. Such a coupling is seen as a closed circuit by the common pole 108 and a signal transmitted by the common pole 108 can propagate to the throw pole 110 if/when also the diode switch circuit 102 is reverse biased. The reverse biasing of the at least one diode 106 of the second diode switch circuit 102 isolates the path 112 from the ground.

Examine now the second quarter wave transmission line 116 and diode switch circuit 102. A cathode side of the at least one diode 106 may be coupled with one pole of the terminating resistor 118. The second pole of the terminating resistor 118 is coupled with the ground. The value of the terminating resistor 118 may be about 50 Ω, for example. When the throw pole 110 is wanted to be terminated, forward current is feed through the at least one diode 106.

When the diode switch of Figure 1A is switched to an ON state, the potential at the anode of the at least one diode 104 of the first diode switch circuit 100 is lower than that at the cathode. Correspondingly, the potential at the anode of the at least one diode 106 of the second diode switch 102 is lower than that at the cathode. Thus, the diodes 104, 106 are reverse biased and a signal can propagate from the common pole 108 to the throw pole 110. The at least one diode 106 of the second diode switch circuit 102 is reverse biased and the path 112 is isolated from ground.

When the diode switch of Figure 1A is switched to an OFF state, the potential at the anode of the at least one diode 104 of the first diode switch circuit 100 is higher than that at the cathode. Correspondingly, the potential at the anode of the at least one diode 106 of the second diode switch circuit 102 is higher than that at the cathode. Thus, the diodes 104, 106 are forward biased and electric current flows through the diodes 104, 106. Thus, a signal cannot propagate from the common pole 108 to the throw pole 110. Because the at least one diode 106 of the second diode switch circuit 102 is forward biased, the path 112 is in contact with ground through the terminating resistor 118.

The ON state of the diode switch circuits 100, 102 means that the signal passes through the signal path 112 from the common pole 108 to the throw pole 110 or from the throw pole 110 to the common pole 108.

The OFF state of the diode switch circuits 100, 102 means that the signal cannot pass through the signal path 112 from the common pole 108 to the throw pole 110 or from the throw pole 110 to the common pole 108.

Termination provides independency of the signal path 112 with respect to an electric circuit outside the signal path 112 i.e. opposite side of the throw pole 110, because of the quarter wave distance between the diode switching circuits 100, 102 in the same signal path. The quarter wave distance between the diode switching circuits 100 and 102 provides an open load for the terminated diode switch circuit 102 towards the first diode switch circuit 100 which makes it unnecessary to use additional stubs in parallel with 50 Ω termination or any other matched termination.

The state of the diode switches 100, 102 may be controlled by a control switch 250. The control switch 250 may comprise at least one control switch element or component.

In an embodiment, a cathode of at least one diode 104 of the first diode switch circuit 100 may be coupled with the ground and an anode of the at least one diode 104 of the first diode switch circuit 100 may be coupled with an end of the first quarter wave transmission line 114.

In an embodiment, a cathode of at least one diode 106 of the second diode switch circuit 102 may have a coupling associated with the ground and an anode of the at least one diode 106 of the second diode switch circuit 102 may have a coupling associated with an end of the second quarter wave transmission line 116 at the throw pole 110 side. In an embodiment, the second diode switch circuit 102 comprises at least one diode 106 and at least one terminating resistor 118 for associating the coupling of the at least one diode 106 with the ground. In an embodiment, the resistance of the at least one terminating resistor 118 may be about 50 Ω, for example, not restricting to this value. In an embodiment, the coupling may be realized such that the terminating resistor 118 is between the at least one diode 106 and the ground. In an embodiment, the coupling may be realized such that the at least one diode 106 is between the terminating resistor 118 and the ground.

In Figure 1A, the at least one diode 104 and the at least one diode 106 may be coupled in the other way round. That is, the cathode of the at least one diode 104 may be in contact with the signal path 112 and the anode of the at least one diode 104 may be in contact with the ground, for example. When the diode switch is switched to an ON state in this kind of diode coupling, the potential difference over the at least one diodes 104, 106 have to be the same as all other cases. The potential at the anode of the at least one diode 104 of the first diode switch circuit 100 is lower than that at the cathode. Correspondingly, the potential at the anode of the at least one diode 106 of the second diode switch 102 is lower than that at the cathode. Thus, the diodes 104, 106 are reverse biased and a signal can propagate from the common pole 108 to the throw pole 110. The at least one diode 106 of the second diode switch circuit 102 is reverse biased and the path 112 is isolated from ground. The potential differences over the at least one diodes 104, 106 in the OFF state are similar to that explained for the coupling of Figure 1.

The value of the terminating resistor 118 may be about 50 Ω or about 75 Ω, for example. In general the value of the terminating resistor 118 is such that it has a good terminating capability. The value of the terminating resistor 118 may depend on the value of the transmission lines 114, 116 which may be of any desirable value. Typical values of transmission lines 114, 116 are 50 Ω and 75 Ω. The value of the terminating resistor 118 may be the same as or at least about the same as that of the transmission lines 114, 116.

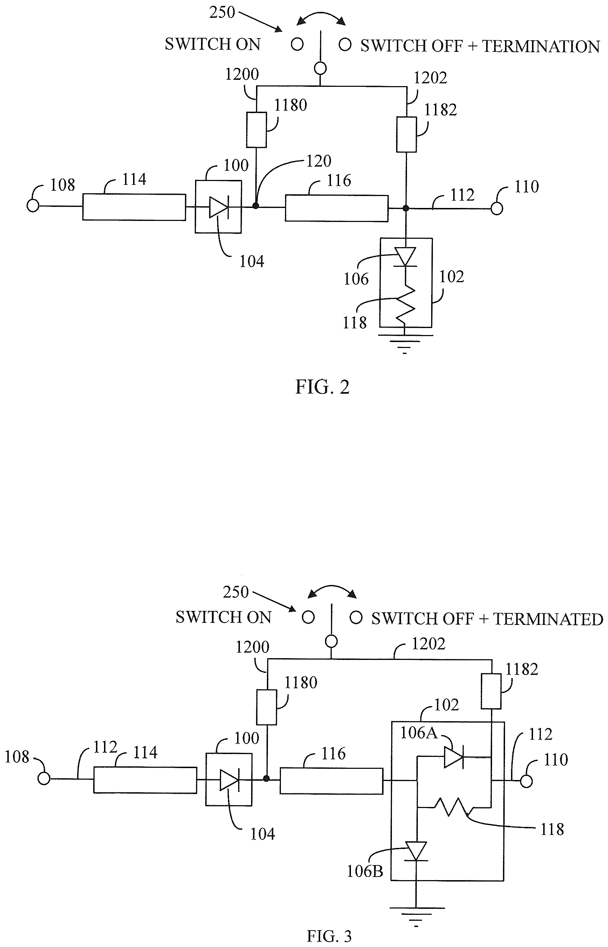

In Figure 1A, a first control resistor 1180 is coupled in series with the first diode switch circuit 100 in a first control branch 1200 and it is electrically coupled between the control switch 250 and the earth below the first diode switch circuit 100. The first control resistor 1180 may reside in a location 1100 between the control switch 250 and the coupling between the transmission lines 114 and 116. The first control resistor 1180 may comprise a plurality of resistor parts which may be distributed in the location 1100 mentioned above. The value of the first control resistor 1180 is the same or at least approximately the same as the value of the terminating resistor 118. In this manner, the same current will flow in branches 1200, 1202 having the diode switch circuits 100, 102 when the semiconductor diode switch is in the OFF state (that is, the diodes 104 and 106 are in an electrically conducting state). The first branch 1200 extends from the control switch 250 to the earth below the diode 104 in Figures 1A and 1B. The second branch 1202 extends from the control switch 250 to the earth below the diode 106 in Figures 1A and 1B. In general, the first branch 1200 extends from the control switch 250 to at least the diode 104 (see Figure 2). In general, the second branch 1202 extends from the control switch 250 to at least the diode 106.

Figure 1B presents an embodiment where a first control resistor 1180 is coupled in the first control branch 1200 and a second control resistor 1182 is coupled in the second control branch 1202. If a value of the second control resistor 1182 is X and a value of the terminating resistor 118 is Y, then the value Z of the first control resistor 1180 is the equal or at least approximately equal to the sum of the values of control resistor 1182 and the terminating resistor 118, that is Z = X + Y. In this manner, the same current will flow in branches 1200, 1202 having the diode switch circuits 100, 102 when the semiconductor diode switch is in the OFF state (that is, the diodes 104 and 106 are in electrically conducting state in Figure 1B).

In this manner, the use of the first control resistor 1180 with or without the second control resistor 1182 makes the diode circuits 100, 102 electrically balanced. An impedance of the first control branch 1200 is balanced at least approximately equal to an impedance of the second control branch 1202 with the first control resistor 1180. That results in reduction of loss and distortion in the diode switch use. Also the isolation of the diode switch is increased.

The capacitors prevent DC-currents and DC-voltages flow in the semiconductor diode switch. Their number and locations may differ from that presented in Figure 1A or 1B. The capacitors have not been drawn in other Figures.

Figure 2 illustrates an example of another configuration of the diode switch. In this embodiment, at least one diode 104 of the first diode switch circuit 100 may be coupled in series with the first quarter wave transmission line 114 and the second quarter wave transmission line 116. In Figure 2, the first control resistor 1180 in the control branch 1200 is coupled in contact with the cathode of first diode switch circuit 100.

In an embodiment, an anode of the at least one diode 104 may be coupled with the first quarter wave transmission line 114 and a cathode of the at least one diode 104 may be coupled with the second quarter wave transmission line 116. Then a voltage level of a coupling point 120 between the cathode of the at least one diode 104 and the second quarter wave transmission line 116 may be lower than that at an anode of the at least one diode 104 in order to feed electric current through the diode 104 and to make a signal transfer possible in the path 112. The same bias at the anode side of the at least one diode circuit 102 may make the diode 106 reverse biased which also enables a signal transfer in the path 112.

When the diode switch of Figure 2 is switched to an ON state, the potential at the cathode of the at least one diode 104 of the first diode switch circuit 100 is lower than that at the anode for feeding electric current therethrough. Correspondingly, the potential at the anode of the at least one diode 106 of the second diode switch circuit 102 is lower than that at the cathode. Thus, the at least one first diode 104 is forward biased and a signal can propagate from the common pole 108 to the throw pole 110. The at least one diode 106 is reverse biased and the path 112 is isolated from the ground.

When the diode switch of Figure 2 is switched to an OFF state, the potential at the cathode of the at least one diode 104 of the first diode switch circuit 100 is higher than that at the anode of the at least one diode 104. Correspondingly, the potential at the anode of the at least one diode 106 of the second diode switch circuit 102 is higher than that at the cathode. Thus, the at least one first diode 104 is reverse biased and a signal cannot propagate from the common pole 108 to the throw pole 110. The at least one diode 106 is forward biased and the path 112 is in contact with the ground through the terminating resistor 118. In the OFF state, the second quarter wave transmission line 116 and the at least one diode 104 may create a theoretically infinite impedance from the throw pole 110 point of view.

In a similar manner to Figure 1B, Figure 2 presents an embodiment where the first control resistor 1180 is coupled in the branch 1200 and the second control resistor 1182 is coupled in the branch 1202. If a value of the resistor 1182 is X and a value of the terminating resistor 118 is Y, then the value Z of the resistor 1180 is the equal or at least approximately equal to the sum of the values of resistors 1182 and 118, that is Z = X + Y. In a case the resistor 1182 doesn't exist or its value is 0 Ω, the resistor 1180 has the same value as the terminating resistor 118 (example in Figure 1A). In this manner, the impedances in branches 1200, 1202 coupled with the diode switch circuits 100, 102 are at least approximately the same. When the semiconductor diode switch is in the OFF state, the diode 106 is in electrically conducting state. When the semiconductor diode switch is in the ON state, the diode 104 is in electrically conducting state. Also this embodiment may have effect in coping with loss and distortion in the diode switch use. The isolation of the diode switch may also in a better control.

Figure 3 illustrates an example of still another configuration of the diode switch. Here the configuration is the same as in Figure 2 from the common pole 108 up to second diode circuit 102.

In an embodiment, at least one diode 106A of the second diode switch circuit 102 may be coupled in series with the first quarter wave transmission line 114 and the second quarter wave transmission line 116.

In an embodiment, a cathode of at least one different diode 106B from the at least one diode 106A in the second diode switch circuit 112 may have a coupling associated with the ground. An anode of the at least one different diode 116B of the second diode switch circuit 102 may have a coupling associated with an end of the second quarter wave transmission line 116 at the throw pole 110 side. This coupling may be called a series termination.

When the diode switch of Figure 3 is switched to an ON state, the potential at cathode of the diodes 104, 106A is lower than that at the anode of the diodes 104, 106A, and the diodes 104, 106A are forward biased. That is why electric current may flow through the diodes 104, 106A and the signal may propagate from the common pole 108 to the throw pole 110. On the other hand, the at least one diode 106B is reverse biased such that the anode is in lower potential than the cathode and the path 112 is isolated from the ground.

When the diode switch of Figure 3 is switched to an OFF state, the potential at cathodes of the diodes 104, 106A is higher than that at the anode of the diodes 104, 106A and the diodes 104, 106A are reverse biased. That is why electric current cannot flow through the diodes 104, 106A and the signal cannot propagate from the common pole 108 to the throw pole 110. On the other hand, the at least one diode 106B is forward biased such that the anode is in higher potential than the cathode and the path 112 is in contact with the ground through impedance 118. The use of the first control resistor 1180 and the second control resistor 1182 makes the diode circuits 100, 102 electrically balanced. That results in loss and distortion reduction in use of the diode switch. Also the isolation of the diode switch is increased. This is important in OFF state.

Also in Figure 3, the value Z of the resistor 1180 is the equal or at least approximately equal to the sum of the values of resistors 1182 and 118, that is Z = X + Y.

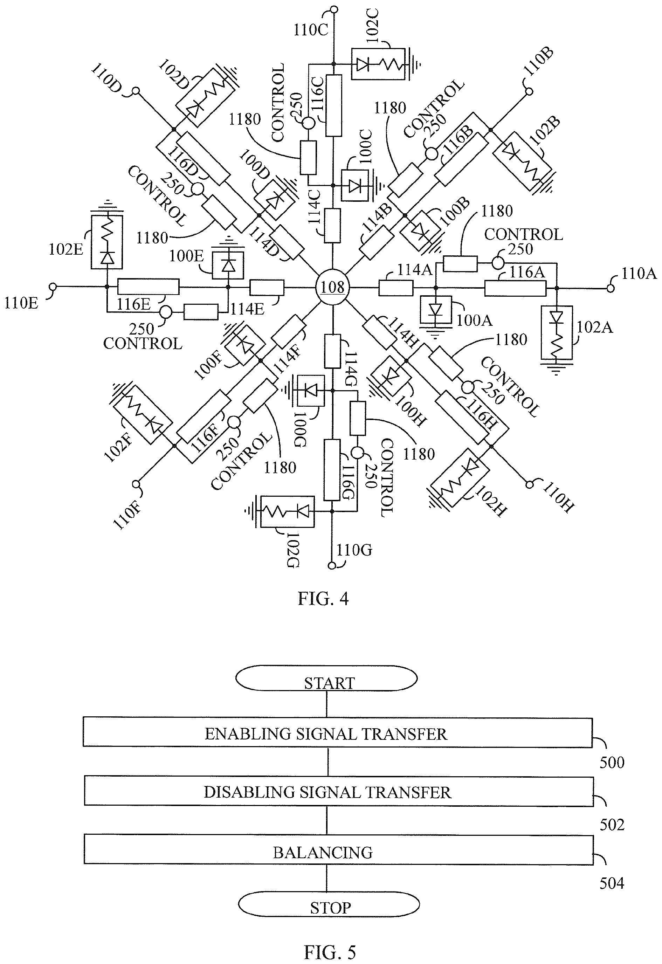

Figure 4 shows an example of a single-pole, multiple-throw (SPMT) diode switch. In the example of Figure 4, the switch has eight paths 112A to 112H. In general, the number of paths 112A to 112H may be at least two. In some cases the number of paths 112A to 112H may be at least three. Each path 112A to 112H is between the common pole 108 and one of the two throw poles 110A to 110H, and the signal transfer between the common pole 108 and one of the two throw poles 110A to 110H may be controlled with diode switch circuits 100A to 100H and 102A to 102H which correspond to the diode switch circuits 100, 102 explained in conjunction with Figures 1 to 3.

Thus, each path 112A to 112H comprises a first diode switch circuit 100A to 100H and a second diode switch circuit 102A to 102H for allowing or blocking the signal transfer between the common pole 108 and each of the throw poles 110A to 110H. In an embodiment, only one path 112A to 112H may be enabled to transfer a signal at a time. The signal transfer may be enabled by reverse biasing the at least one the ground coupled diode 104 of the first diode switch circuit 100A to 100H in Figure 4 which has the same diode switch configuration as shown in Figure 1.

When a single path 112A to 112H is enabled for signal transfer, other paths 112A to 112H may be disabled by forward biasing a ground coupled diode 104 of the first diode switch circuit 102A to 102H.

If an embodiment according to couplings of Figures 2 and 3 is used in the diode switch configuration of Figure 4, the signal transfer is enabled by forward biasing the at least one serially coupled diode 104 of the first diode switch circuit 102A to 102H. Using the coupling of Figures 2 and 3, the signal transfer may be disabled in other paths 112A to 112H by reverse biasing a serially coupled diode 104 of a first diode switch circuit 102A to 102H.

Each diode in the diode switch circuits 100A to 100H and 102A to 102H may be controlled either to forward direction or to reverse direction. A diode is considered to be forward biased when a constant current is driven through it. This is possible when a voltage higher than that of cathode is applied to the anode. Current may be adjusted according to required linearity and insertion loss requirements. A diode is considered to be reverse biased when a voltage lower than that of cathode is applied to the anode. In a reverse state no current flows through the diode, in principle.

When throw poles 110A to 110H are desired to be isolated from the common pole 108 and from the other paths 112A to 112H, diode switch circuits 100A to 100H and 102A to 102H may be switched to an OFF state. The OFF state may be realised by driving the diodes 104A to 104H of the diode switch circuits 100A to 100H to the forward direction in coupling configurations according to Figure 4. The coupling configuration in Figure 4 is similar to that of Figure 1A also with respect to the first control resistor 1180. The coupling configuration of Figure 4 may also be realized with couplings shown in Figures 1B, 2 and 3.

In the path(s) 112A to 112H through which a signal is desired to be connected between the common pole 108 and at least one throw pole 110A to 110H, negative voltage is applied to corresponding diode anode(s) of the diode switch circuit(s) 100A to 100H. This disconnects corresponding path(s) 112A to 112H from the termination. Diode parasitics may affect the signal although the signal is transmitted between the common pole 108 and the at least one throw pole 110A to 110H which are switched to a conducting state regardless of the signal direction.

The state of the diode switches 100A to 100H, 102A to 102H may be controlled by a control switch 250A to 250H which corresponds to the control switch 25. The control switch 250, 250A to 250H may comprise at least one control switch element or component.

In Figure 4, the common pole 108 is in the middle of the structure, so it does restrict dimensions of the diode switch which enables a small structure, for example.

In Figure 4, different (RF) paths 112A to 112H are in parallel. A connection between the common pole 108 and the throw poles 110A to 110H can be switched using the diode switches. Each of the different paths have the same dimension as the other ones. After the final point of the structure i.e. throw poles 110, 110A to 110H, radio frequency impedances do not have effect on the performance of the switch.

In any coupling presented in Figures 1 to 4, the diodes may be coupled in the other way round. By applying a positive voltage to the anode of a diode with respect to cathode of the diode, the diode may be switched in a conductive state. By applying a positive voltage to the cathode of a diode with respect to the anode of the diode, the diode may be switched in a nonconductive state. If there is a conductive state between the ground and the signal path 112, the diode switch in an OFF state where a signal cannot pass from the common pole 108 to a throw pole 110 or vice versa. If there is a nonconductive state between the ground and the signal path 112 and potentially there is a conductive state in the signal path 112 (Figures 2 and 3), the diode switch in an ON state where a signal can pass from the common pole 108 to a throw pole 110 or vice versa.

As can be seen in Figure 4, the switch coupling may comprise components in addition to diodes, transmission lines and terminating impedances. Such additional components may comprise capacitors and inductors, for example. The additional components may be in parallel or series coupling with respect to at least one quarter wave transmission line 114, 116.

The RF path which is switched ON is provided with minimal insertion loss, while those RF pats which have been switched in a disconnected state are electrically isolated and may be terminated in 50 Ω or the like. The main electrical characteristics for the diode radio frequency switch include small size, small insertion loss, good isolation, good matching, fast switching speed and good power handling capability which may be fulfilled with the diode switch described in this application.

Each control switch 250 (word CONTROL in Figure 4) may cause both diode switch circuits 100A to 100H and 102A to 102H in a path 112A to 112H to switch to the same state with a single control action. The state may be ON or OFF for the path 112A to 112H. The resistance corresponding to terminal resistance may be coupled in series with the anode of the first diode of the diode switch 100A to 100H with one control action for both diode switch circuits 100A to 100H and 102A to 102H in one path 112A to 112H, for example. Similarly, the resistance corresponding to terminal resistance may be decoupled from series coupling with the anode of the first diode of the diode switch 100A to 100H with one control action for both diode switch circuits 100A to 100H and 102A to 102H in one path 112A to 112H, for example.

In general, the semiconductor diode switch comprises, associated with each signal path 112A to 112H, the first control branch 1200 with a first control resistor 1180 couples the first diode switch 100A to 100H to the control switch 250. The second control branch 1202 couples the second diode switch 102A to 102H to the control switch 250 and terminates the second diode switch circuit 102A to 102H through the at least one terminating resistor 118. An impedance value of the first control resistor 1180 is at least approximately equal to an impedance of the second control branch 1202. The first diode switch circuit 100A to 100H and the second diode switch 102A to 102H allow or block a signal transfer between the common pole 108 and a throw pole 110A to 110H on the basis of a control from the control switch 250.

Following advantages may be achieved compared to some other possible switch couplings. Other possible couplings use SPDT switches in series.

A small size may be achieved, because of the parallel construction of the different paths. The paths 112A to 112H between the common pole 108 and the throw poles 110A to 110H may be in circular form. The small size may be based on a planar structure on a printed wiring board (PWB).

Low insertion loss may be achieved by minimising transmission line lengths which on the other hand may be possible because of the structure and couplings. Low insertion loss may be achieved by proper dimensioning of the transmission lines. Low insertion loss may also be achieved by minimising the number of the diodes in the structure.

Low Insertion loss may be based on high power handling which, in turn, may be achieved by the usage of PIN diodes.

Low Insertion loss may be based on terminated output impedance which can be easily controlled.

Low Insertion loss may be based on common RF port which is in the middle of the structure, thus providing the best symmetric structure. RF connector from other modules can be easily connected there. It is also possible to contact common feed point through other layers in PWB build-up.

High isolation, which is required between antenna ports, may be achieved by having certain dimensions on the signal paths.

Solution can be implemented on a multilayer PWB board, which means it can be in small scale in Z-direction compared to current commercially available solution. Two dimensional XY - scale depends on the frequency range used.

The solution in this application refers to high-power SPMT switch. The switch may be absorptive which means that it typically has a low voltage SWR (VSWR) in its ON and OFF states. The absorptive switch may also be called non-reflective or terminated switch and it is useful because it doesn't generate harmful reflections.

The original equipment manufacturers and operators accept the parallel coupling of the diode switches.

The diode switch may be designed for a certain frequency range, but can be scaled for different frequency bands.

The diode switch may be applied in wide range of fields such as mobile communication and testing, satellite communication, broadcasting, radars, for example.

Therefore the diode switch may be suitable for example:
- Active antenna arrays
- Special remote radio heads
- Beam forming structures
- All RF products, which requires small space and multiple signal path selection at high power levels.

The connection of a single antenna connector of a base station to a multiple selection of antennas may be made more easily and effectively than in the prior art. The structure can be scaled upwards and downwards depending on the number of connected ports.

The switching method for a semiconductor diode switch is shown in Figure 5. In step 500, a signal transfer through at least one path 112A to 112H of the paths 112A to 112H is enabled by switching a first diode switch circuit 100A to 100H and a second diode switch circuit 102A to 102H between which there is a second quarter wave transmission line 116A to 116H to an ON mode by passing, from a control switch 250, an ON control through a control branch 1200 having a first control resistor 1180 to the first diode switch 100A to 100H, and passing, from the control switch 250, the ON control to the second diode switch 102A to 102H. In step 502, the signal transfer through at least one path 112A to 112H of the paths 112A to 112H is disabled by switching the first diode switch circuit 100A to 100H and the second diode switch circuit 102A to 102H to an OFF mode where the second diode switch circuit 102A to 102H has a terminating resistor 118 in a second control branch 1182 for terminating the signal path 112A to 112H by passing, from a control switch 250, an OFF control through the control branch 1200 having the control resistor 1180 to the first diode switch 100A to 100H, and passing, from the control switch 250, the OFF control to the second diode switch 102A to 102H. In step 504, an impedance of the first control branch 1200 is balanced at least approximately equal to an impedance of the second control branch 1202 with the first control resistor 1180.

The position of the control switch 250, 250A to 250H may be set by at least one logic circuit solution or computer program. The at least one computer program may be placed on a computer program distribution means for the distribution thereof. The computer program distribution means is readable by at least one data processing device for encoding the computer program commands and carrying out the actions.

The distribution medium, in turn, may be a medium readable by a data processing device, a program storage medium, a memory readable by a data processing device, a software distribution package readable by a data processing device, a signal readable by a data processing device, a telecommunications signal readable by a data processing device, or a compressed software package readable by a data processing device.

## Claims

1. A semiconductor diode switch, wherein the switch comprises a common pole (108), at least two throw poles (110, 110A to 110H) and signal paths (112, 112A to 112H), each of the signal paths (112, 112A to 112H) being between the common pole (108) and one of the at least two throw poles (110, 110A to 110H),
the semiconductor diode switch comprising, associated with each signal path (112, 112A to 112H), a first diode switch circuit (100, 100A to 100H), and a second diode switch circuit (102, 102A to 102H) with at least one terminating resistor (118);
a first quarter wave transmission line (114, 114A to 114H) between the common pole (108) and the first diode switch circuit (100, 100A to 100H), a second quarter wave transmission line (116), residing between the first diode switch (100, 100A to 100 H) and the second diode switch circuit (102, 102A to 102H); the first diode switch circuit (100, 100A to 100H) having a coupling to the path (112, 112A to 112H) between the first quarter wave transmission line (114, 114A to 114H) and the second quarter wave transmission line (116, 116A to 116H),
a first control branch (1200) with a first control resistor (1180) coupled to the path (112, 112A to 112H) between the first and second quarter wave transmission line (114, 114A to 114H; 116, 116A to 116H) and configured to couple the first diode switch (100, 100A to 100H) to a control switch (250);
a second control branch (1202) configured to couple the second diode switch (102, 102A to 102H) to the control switch (250) and terminate the second diode switch circuit (102, 102A to 102H) through the at least one terminating resistor (118), an impedance value of the first control resistor (1180) being at least approximately equal to an impedance of the second control branch (1202), the terminating resistor (118) being between the second diode switch circuit (102, 102A to 102H) and the ground, or the second diode switch circuit (102, 102A to 102H) being between the terminating resistor (118) and the ground; and
the first diode switch circuit (100, 100A to 100H) and the second diode switch (102, 102A to 102H) being configured to allow or block a signal transfer between the common pole (108) and a throw pole (110, 110A to 110H) on the basis of a control from the control switch (250).

2. The diode switch as claimed in claim 1, **characterized in that** associated with each signal path (112, 112A to 112H) the second control branch (1202) has a second control resistor (1182); and an impedance value of the first control resistor (1180) being at least approximately equal to a sum of an impedance of the second control resistor (1182) and an impedance of the terminating resistor (118).

3. The diode switch as claimed in claim 1, wherein a cathode of at least one semiconductor diode (104) of the first diode switch circuit (100, 100A to 100H) is coupled with the ground and an anode of the at least one diode (104) of the first diode switch circuit (100, 100A to 100H) is coupled with the first quarter wave transmission line (114, 114A to 114B).

4. The diode switch as claimed in claim 1, wherein a cathode of at least one semiconductor diode (106, 106A, 106B) of the second diode switch circuit (102, 102A to 102H) has a coupling associated with the ground and an anode of the at least one diode (106) of the second diode switch circuit (102, 102A to 102H) has a coupling associated with an end of the second quarter wave transmission line (116, 116A to 116H) at the throw pole (110, 110A to 110H) side.

5. The diode switch as claimed in claim 1, wherein at least one semiconductor diode (104) of the first diode switch circuit (100, 100A to 100H) is coupled in series with the first quarter wave transmission line (114, 114A to 114H) and the second quarter wave transmission line (116, 116A to 116H).

6. The diode switch as claimed in claim 1, wherein at least one semiconductor diode (106A) of the second diode switch circuit (102, 102A to 102H) is coupled in series with the first quarter wave transmission line (114, 114A to 114H) and the second quarter wave transmission line (116, 116A to 116H), and a cathode of at least one different semiconductor diode (106B) of the second diode switch circuit (102, 102A to 102H) has a coupling associated with the ground and an anode of the at least one different diode (106B) of the second diode switch circuit (102, 102A to 102H) has a coupling associated with an end of the second quarter wave transmission line (116, 116A to 116H) at the throw pole (110, 110A to 110H) side.

7. A switching method for a semiconductor diode switch, wherein the switch comprises a common pole (108), at least two throw poles (110, 110A to 110H) and signal paths (112, 112A to 112H), each of the signal paths (112, 112A to 112H) being between the common pole (108) and one of the at least two throw poles (110, 110A to 110H), and a first quarter wave transmission line (114, 114A to 114H) being between the common pole (108) and the first diode switch circuit (100, 100A to 100H), the first diode switch circuit (100A to 100H) having a coupling to the path (112, 112A to 112H) between the first quarter wave transmission line (114, 114A to 114H) and a second quarter wave transmission line (116, 116A to 116H); and
enabling (500), by a first control branch (1200) with a first control resistor (1180) coupled to the path (112, 112A to 112H) between the first and second quarter wave transmission lines (114, 114A to 114H; 116, 116A to 116H), a signal transfer through at least one signal path (112, 112A to 112H) of the signal paths (112, 112A to 112H) by switching a first diode switch circuit (100, 100A to 100H) and a second diode switch circuit (102, 102A to 102H) between which there is the second quarter wave transmission line (116, 116A to 116H) to an ON mode by passing, from a control switch (250), an ON control through the first control branch (1200) having the first control resistor (1180) to the first diode switch (100, 100A to 100H), and passing, from the control switch (250), the ON control to the second diode switch (102, 102A to 102H);
disabling (502) a signal transfer through a signal path (112, 112A to 112H) by switching the first diode switch circuit (100, 100A to 100H) and the second diode switch circuit (102, 102A to 102H) to an OFF mode, where a terminating resistor (118) being between the second diode switch circuit (102, 102A to 102H) and the ground, or the second diode switch circuit (102, 102A to 102H) being between the terminating resistor (118) and the ground in a second control branch (1202) for terminating the signal path (112, 112A to 112H) by passing, from a control switch (250), an OFF control through the control branch (1200) having the control resistor (1180) to the first diode switch (100A to 100H), and passing, from the control switch (250), the OFF control to the second diode switch (102, 102A to 102H); and
balancing (504) an impedance of the first control branch (1200) at least approximately equal to an impedance of the second control branch (1202) with the first control resistor (1180).

8. The method as claimed in claim 7, wherein with each signal path (112, 112A to 112H) the second control branch (1202) has a second control resistor (1182); and the impedance value of the first control resistor (1180) being at least approximately equal to a sum of an impedance of the second control resistor (1182) and an impedance of the terminating resistor (118).

9. The method as claimed in claim 7, the method further comprising enabling the signal transfer by reverse biasing at least one semiconductor diode (104) of the first diode switch circuit (100, 100A to 100H) and disabling the signal transfer by forward biasing at least one semiconductor diode (104) of the first diode switch circuit (100, 100A to 100H), wherein a cathode of the at least one semiconductor diode (104) of the first diode switch circuit (100, 100A to 100H) being coupled with the ground and an anode of the at least one diode (104) of the first diode switch circuit (100, 100A to 100H) being coupled with the first quarter wave transmission line (114, 114A to 114B).

10. The method as claimed in claim 7 or 9, wherein a cathode of at least one semiconductor diode (106, 106A, 106B) of the second diode switch circuit (102, 102A to 102H) has a coupling associated with the ground and an anode of the at least one diode (106) of the second diode switch circuit (102, 102A to 102H) has a coupling associated with an end of the second quarter wave transmission line (116, 116A to 116H) at the throw pole (110, 110A to 110H) side.

11. The method as claimed in claim 7, the method further comprising enabling the signal transfer by forward biasing at least one semiconductor diode (104) of the first diode switch circuit (100, 100A to 100H), wherein at least one semiconductor diode (104) of the first diode switch circuit (100, 100A to 100H) is coupled in series with the first quarter wave transmission line (114, 114A to 114H) and the second quarter wave transmission line (116, 116A to 116H).

12. The method as claimed in claim 7, wherein a cathode of at least one semiconductor diode (106) of the second diode switch circuit (102, 102A to 102H) has a coupling associated with the ground and an anode of the at least one diode (106) of the second diode switch circuit (102, 102A to 102H) has a coupling associated with an end of the second quarter wave transmission line (116, 116A to 116H) at the throw pole (110, 110A to 110H) side.

13. The method as claimed in claim 7, the method further comprising enabling the signal transfer by forward biasing at least one semiconductor diode (106A) of the second diode switch circuit (102, 102A to 102H) and by reverse biasing at least one different semiconductor diode (106B) of the second diode switch circuit (102, 102A to 102H), and disabling the signal transfer by reverse biasing at least one semiconductor diode (106A) of the second diode switch circuit (102, 102A to 102H) and forward biasing the at least one different semiconductor diode (106B) of the second diode switch circuit (102, 102A to 102H), wherein
at least one semiconductor diode (106A) of the second diode switch circuit (102, 102A to 102H) is coupled in series with the first quarter wave transmission line (114, 114A to 114H) and the second quarter wave transmission line (116, 116A to 116H), and a cathode of at least one different semiconductor diode (106B) of the second diode switch circuit (102, 102A to 102H) has a coupling associated with the ground and an anode of the at least one different diode (106B) of the second diode switch circuit (102, 102A to 102H) has a coupling associated with an end of the second quarter wave transmission line (116, 116A to 116H) at the throw pole (110, 110A to 110H) side.

## Patentansprüche

1. Halbleiterdiodenschalter, wobei der Schalter einen gemeinsamen Pol (108), mindestens zwei Umschaltpole (110, 110A bis 110H) und Signalpfade (112, 112A bis 112H) umfasst, wobei jeder der Signalpfade (112, 112A bis 112H) zwischen dem gemeinsamen Pol (108) und einem der mindestens zwei Umschaltpole (110, 110A bis 110H) verläuft,
Halbleiterdiodenschalter, der eine erste Diodenschaltschaltung (100, 100A bis 100H) und eine zweite Diodenschaltschaltung (102, 102A bis 102H) mit mindestens einem Abschlusswiderstand (118) umfasst, die mit jedem Signalpfad (112, 112A bis 112H) verknüpft sind;
eine erste Viertelwellenübertragungsleitung (114, 114A bis 114H) zwischen dem gemeinsamen Pol (108) und der ersten Diodenschaltschaltung (100, 100A bis 100H), eine zweite Viertelwellenübertragungsleitung (116), die sich zwischen dem ersten Diodenschalter (100, 100A bis 100 H) und der zweiten Diodenschaltschaltung (102, 102A bis 102H) befindet;
wobei die erste Diodenschaltschaltung (100, 100A bis 100H) eine Kopplung zum Pfad (112, 112A bis 112H) zwischen der ersten Viertelwellenübertragungsleitung (114, 114A bis 114H) und der zweiten Viertelwellenübertragungsleitung (116, 116A bis 116H) aufweist,
einen ersten Steuerzweig (1200), der einen ersten Steuerwiderstand (1180) aufweist, der an den Pfad (112, 112A bis 112H) zwischen der ersten und der zweiten Viertelwellenübertragungsleitung (114, 114A bis 114H; 116, 116A bis 116H) gekoppelt und dazu ausgelegt ist, den ersten Diodenschalter (100, 100A bis 100H) an einen Steuerschalter (250) zu koppeln;
einen zweiten Steuerzweig (1202), der dazu ausgelegt ist, den zweiten Diodenschalter (102, 102A bis 102H) an den Steuerschalter (250) zu koppeln und die zweite Diodenschaltschaltung (102, 102A bis 102H) durch den mindestens einen Abschlusswiderstand (118) abzuschließen, wobei ein Impedanzwert des ersten Steuerwiderstands (1180) mit einer Impedanz des zweiten Steuerzweigs (1202) mindestens ungefähr gleich ist, wobei sich der Abschlusswiderstand (118) zwischen der zweiten Diodenschaltschaltung (102, 102A bis 102H) und der Masse befindet oder sich die zweite Diodenschaltschaltung (102, 102A bis 102H) zwischen dem Abschlusswiderstand (118) und der Masse befindet; und
wobei die erste Diodenschaltschaltung (100, 100A bis 100H) und der zweite Diodenschalter (102, 102A bis 102H) dazu ausgelegt sind, eine Signalübermittlung zwischen dem gemeinsamen Pol (108) und einem Umschaltpol (110, 110A bis 110H) auf Basis einer Steuerung vom Steuerschalter (250) zuzulassen oder zu blockieren.

2. Diodenschalter nach Anspruch 1, **dadurch gekennzeichnet, dass**, verknüpft mit jedem Signalpfad (112, 112A bis 112H), der zweite Steuerzweig (1202) einen zweiten Steuerwiderstand (1182) aufweist und ein Impedanzwert des ersten Steuerwiderstands (1180) mindestens ungefähr gleich einer Summe einer Impedanz des zweiten Steuerwiderstands (1182) und einer Impedanz des Abschlusswiderstands (118) ist.

3. Diodenschalter nach Anspruch 1, wobei eine Katode von mindestens einer Halbleiterdiode (104) der ersten Diodenschaltschaltung (100, 100A bis 100H) an die Masse gekoppelt ist und eine Anode der mindestens einen Diode (104) der ersten Diodenschaltschaltung (100, 100A bis 100H) an die erste Viertelwellenübertragungsleitung (114, 114A bis 114B) gekoppelt ist.

4. Diodenschalter nach Anspruch 1, wobei eine Katode von mindestens einer Halbleiterdiode (106, 106A, 106B) der zweiten Diodenschaltschaltung (102, 102A bis 102H) eine Kopplung aufweist, die mit der Masse verknüpft ist, und eine Anode der mindestens einen Diode (106) der zweiten Diodenschaltschaltung (102, 102A bis 102H) eine Kopplung aufweist, die auf der Seite der Umschaltpole (110, 110A bis 110H) mit einem Ende der zweiten Viertelwellenübertragungsleitung (116, 116A bis 116H) verknüpft ist.

5. Diodenschalter nach Anspruch 1, wobei mindestens eine Halbleiterdiode (104) der ersten Diodenschaltschaltung (100, 100A bis 100H) mit der ersten Viertelwellenübertragungsleitung (114, 114A bis 114H) und der zweiten Viertelwellenübertragungsleitung (116, 116A bis 116H) in Reihe gekoppelt ist.

6. Diodenschalter nach Anspruch 1, wobei mindestens eine Halbleiterdiode (106A) der zweiten Diodenschaltschaltung (102, 102A bis 102H) mit der ersten Viertelwellenübertragungsleitung (114, 114A bis 114H) und der zweiten Viertelwellenübertragungsleitung (116, 116A bis 116H) in Reihe gekoppelt ist und eine Katode von mindestens einer anderen Halbleiterdiode (106B) der zweiten Diodenschaltschaltung (102, 102A bis 102H) eine Kopplung aufweist, die mit der Masse verknüpft ist, und eine Anode der mindestens einen anderen Diode (106B) der zweiten Diodenschaltschaltung (102, 102A bis 102H) eine Kopplung aufweist, die auf der Seite der Umschaltpole (110, 110A bis 110H) mit einem Ende der zweiten Viertelwellenübertragungsleitung (116, 116A bis 116H) verknüpft ist.

7. Schaltverfahren für einen Halbleiterdiodenschalter, wobei der Schalter einen gemeinsamen Pol (108), mindestens zwei Umschaltpole (110, 110A bis 110H) und Signalpfade (112, 112A bis 112H) umfasst,
wobei jeder der Signalpfade (112, 112A bis 112H) zwischen dem gemeinsamen Pol (108) und einem der mindestens zwei Umschaltpole (110, 110A bis 110H) verläuft und eine erste Viertelwellenübertragungsleitung (114, 114A bis 114H) zwischen dem gemeinsamen Pol (108) und der ersten Diodenschaltschaltung (100, 100A bis 100H) verläuft, wobei die erste Diodenschaltschaltung (100A bis 100H) eine Kopplung zum Pfad (112, 112A bis 112H) zwischen der ersten Viertelwellenübertragungsleitung (114, 114A bis 114H) und einer zweiten Viertelwellenübertragungsleitung (116, 116A bis 116H) aufweist; und
Aktivieren (500), durch einen ersten Steuerzweig (1200), der einen ersten Steuerwiderstand (1180) aufweist, der an den Pfad (112, 112A bis 112H) zwischen der ersten und der zweiten Viertelwellenübertragungsleitung (114, 114A bis 114H; 116, 116A bis 116H) gekoppelt ist, einer Signalübermittlung über mindestens einen Signalpfad (112, 112A bis 112H) der Signalpfade (112, 112A bis 112H) durch Schalten einer ersten Diodenschaltschaltung (100, 100A bis 100H) und einer zweiten Diodenschaltschaltung (102, 102A bis 102H), zwischen denen sich die zweite Viertelwellenübertragungsleitung (116, 116A bis 116H) befindet, in einen EIN-Modus, indem eine EIN-Steuerung von einem Steuerschalter (250) durch den ersten Steuerzweig (1200), der den ersten Steuerwiderstand (1180) aufweist, zum ersten Diodenschalter (100, 100A bis 100H) geleitet wird und die EIN-Steuerung vom Steuerschalter (250) zum zweiten Diodenschalter (102, 102A bis 102H) geleitet wird;
Deaktivieren (502) einer Signalübermittlung über einen Signalpfad (112, 112A bis 112H) durch Schalten der ersten Diodenschaltschaltung (100, 100A bis 100H) und der zweiten Diodenschaltschaltung (102, 102A bis 102H) in einen AUS-Modus, wobei sich ein Abschlusswiderstand (118) zwischen der zweiten Diodenschaltschaltung (102, 102A bis 102H) und der Masse befindet oder wobei sich die zweite Diodenschaltschaltung (102, 102A bis 102H) zum Abschließen des Signalpfads (112, 112A bis 112H) zwischen dem Abschlusswiderstand (118) und der Masse in einem zweiten Steuerzweig (1202) befindet, indem eine AUS-Steuerung von einem Steuerschalter (250) durch den Steuerzweig (1200), der den Steuerwiderstand (1180) aufweist, zum ersten Diodenschalter (100A bis 100H) geleitet wird und die AUS-Steuerung vom Steuerschalter (250) zum zweiten Diodenschalter (102, 102A bis 102H) geleitet wird; und
Ausgleichen (504) einer Impedanz des ersten Steuerzweigs (1200) einer Impedanz des zweiten Steuerzweigs (1202) mindestens ungefähr gleich mit dem ersten Steuerwiderstand (1180) .

8. Verfahren nach Anspruch 7, wobei der zweite Steuerzweig (1202) bei jedem Signalpfad (112, 112A bis 112H), einen zweiten Steuerwiderstand (1182) aufweist und der Impedanzwert des ersten Steuerwiderstands (1180) mindestens ungefähr gleich einer Summe einer Impedanz des zweiten Steuerwiderstands (1182) und einer Impedanz des Abschlusswiderstands (118) ist.

9. Verfahren nach Anspruch 7, wobei das Verfahren ferner das Aktivieren der Signalübermittlung durch Vorspannen von mindestens einer Halbleiterdiode (104) der ersten Diodenschaltschaltung (100, 100A bis 100H) in Sperrrichtung und das Deaktivieren der Signalübermittlung durch Vorspannen von mindestens einer Halbleiterdiode (104) der ersten Diodenschaltschaltung (100, 100A bis 100H) in Durchlassrichtung umfasst, wobei die Katode von mindestens einer Halbleiterdiode (104) der ersten Diodenschaltschaltung (100, 100A bis 100H) an die Masse gekoppelt ist und eine Anode der mindestens einen Diode (104) der ersten Diodenschaltschaltung (100, 100A bis 100H) an die erste Viertelwellenübertragungsleitung (114, 114A bis 114B) gekoppelt ist.

10. Verfahren nach Anspruch 7 oder 9, wobei eine Katode von mindestens einer Halbleiterdiode (106, 106A, 106B) der zweiten Diodenschaltschaltung (102, 102A bis 102H) eine Kopplung aufweist, die mit der Masse verknüpft ist, und eine Anode der mindestens einen Diode (106) der zweiten Diodenschaltschaltung (102, 102A bis 102H) eine Kopplung aufweist, die auf der Seite der Umschaltpole (110, 110A bis 110H) mit einem Ende der zweiten Viertelwellenübertragungsleitung (116, 116A bis 116H) verknüpft ist.

11. Verfahren nach Anspruch 7, wobei das Verfahren ferner das Aktivieren einer Signalübermittlung durch Vorspannen von mindestens einer Halbleiterdiode (104) der ersten Diodenschaltschaltung (100, 100A bis 100H) in Durchlassrichtung umfasst, wobei mindestens eine Halbleiterdiode (104) der ersten Diodenschaltschaltung (100, 100A bis 100H) mit der ersten Viertelwellenübertragungsleitung (114, 114A bis 114H) und der zweiten Viertelwellenübertragungsleitung (116, 116A bis 116H) in Reihe gekoppelt ist.

12. Verfahren nach Anspruch 7, wobei eine Katode von mindestens einer Halbleiterdiode (106) der zweiten Diodenschaltschaltung (102, 102A bis 102H) eine Kopplung aufweist, die mit der Masse verknüpft ist, und eine Anode der mindestens einen Diode (106) der zweiten Diodenschaltschaltung (102, 102A bis 102H) eine Kopplung aufweist, die auf der Seite der Umschaltpole (110, 110A bis 110H) mit einem Ende der zweiten Viertelwellenübertragungsleitung (116, 116A bis 116H) verknüpft ist.

13. Verfahren nach Anspruch 7, wobei das Verfahren ferner das Aktivieren der Signalübermittlung durch Vorspannen von mindestens einer Halbleiterdiode (106A) der zweiten Diodenschaltschaltung (102, 102A bis 102H) in Durchlassrichtung und durch Vorspannen von mindestens einer anderen Halbleiterdiode (106B) der zweiten Diodenschaltschaltung (102, 102A bis 102H) in Sperrrichtung und das Deaktivieren der Signalübermittlung durch Vorspannen von mindestens einer Halbleiterdiode (106A) der zweiten Diodenschaltschaltung (102, 102A bis 102H) in Sperrrichtung und Vorspannen der mindestens einen anderen Halbleiterdiode (106B) der zweiten Diodenschaltschaltung (102, 102A bis 102H) in Durchlassrichtung umfasst, wobei
mindestens eine Halbleiterdiode (106A) der zweiten Diodenschaltschaltung (102, 102A bis 102H) mit der ersten Viertelwellenübertragungsleitung (114, 114A bis 114H) und der zweiten Viertelwellenübertragungsleitung (116, 116A bis 116H) in Reihe gekoppelt ist und eine Katode von mindestens einer anderen Halbleiterdiode (106B) der zweiten Diodenschaltschaltung (102, 102A bis 102H) eine Kopplung aufweist, die mit der Masse verknüpft ist, und eine Anode der mindestens einen anderen Diode (106B) der zweiten Diodenschaltschaltung (102, 102A bis 102H) eine Kopplung aufweist, die auf der Seite der Umschaltpole (110, 110A bis 110H) mit einem Ende der zweiten Viertelwellenübertragungsleitung (116, 116A bis 116H) verknüpft ist.

## Revendications

1. Commutateur à diodes à semi-conducteurs, dans lequel le commutateur comprend un pôle commun (108), au moins deux pôles de direction (110, 110A à 110H) et des trajets de signaux (112, 112A à 112H), dans lequel chacun des trajets de signaux (112, 112A à 112H) est entre le pôle commun (108) et l'un desdits au moins deux pôles de direction (110, 110A à 110H) ,
dans lequel le commutateur à diodes à semi-conducteurs comprend, associé à chaque trajet de signal (112, 112A à 112H), un premier circuit de commutation à diodes (100, 100A à 100H), et un deuxième circuit de commutation à diodes (102, 102A à 102H) avec au moins une résistance de terminaison (118) ;
une première ligne de transmission quart d'onde (114, 114A à 114H) entre le pôle commun (108) et le premier circuit de commutation à diodes (100, 100A à 100H),
une deuxième ligne de transmission quart d'onde (116), qui se trouve entre le premier commutateur à diodes (100, 100A à 100H) et le deuxième circuit de commutation à diodes (102, 102A à 102H) ;
dans lequel le premier circuit de commutation à diodes (100, 100A à 100H) est couplé au trajet (112, 112A à 112H) entre la première ligne de transmission quart d'onde (114, 114A à 114H) et la deuxième ligne de transmission quart d'onde (116, 116A à 116H),
une première branche de commande (1200) avec une première résistance de commande (1180) couplée au trajet (112, 112A à 112H) entre les première et deuxième lignes de transmission quart d'onde (114, 114A à 114H ; 116, 116A à 116H) et configurée pour coupler le premier commutateur à diodes (100, 100A à 100H) à un commutateur de commande (250) ;
une deuxième branche de commande (1202) configurée pour coupler le deuxième commutateur à diodes (102, 102A à 102H) au commutateur de commande (250) et terminer le deuxième circuit de commutation à diodes (102, 102A à 102H) par ladite au moins une résistance de terminaison (118), dans lequel une valeur d'impédance de la première résistance de commande (1180) est au moins à peu près égale à une impédance de la deuxième branche de commande (1202), la résistance de terminaison (118) est entre le deuxième circuit de commutation à diodes (102, 102A à 102H) et la masse, ou le deuxième circuit de commutation à diodes (102, 102A à 102H) est entre la résistance de terminaison (118) et la masse ; et
dans lequel le premier circuit de commutation à diodes (100, 100A à 100H) et le deuxième commutateur à diodes (102, 102A à 102H) sont configurés pour autoriser ou bloquer un transfert de signal entre le pôle commun (108) et un pôle de direction (110, 110A à 110H) sur la base d'une commande provenant du commutateur de commande (250).

2. Commutateur à diodes selon la revendication 1, **caractérisé en ce que**, associée à chaque trajet de signal (112, 112A à 112H), la deuxième branche de commande (1202) a une deuxième résistance de commande (1182) ; et une valeur d'impédance de la première résistance de commande (1180) est au moins à peu près égale à une somme d'une impédance de la deuxième résistance de commande (1182) et d'une impédance de la résistance de terminaison (118).

3. Commutateur à diodes selon la revendication 1, dans lequel une cathode d'au moins une diode à semi-conducteurs (104) du premier circuit de commutation à diodes (100, 100A à 100H) est couplée à la masse et une anode de ladite au moins une diode (104) du premier circuit de commutation à diodes (100, 100A à 100H) est couplée à la première ligne de transmission quart d'onde (114, 114A à 114B).

4. Commutateur à diodes selon la revendication 1, dans lequel une cathode d'au moins une diode à semi-conducteurs (106, 106A, 106B) du deuxième circuit de commutation à diodes (102, 102A à 102H) a un couplage associé à la masse et une anode de ladite au moins une diode (106) du deuxième circuit de commutation à diodes (102, 102A à 102H) a un couplage associé à une extrémité de la deuxième ligne de transmission quart d'onde (116, 116A à 116H) du côté pôle de direction (110, 110A à 110H).

5. Commutateur à diodes selon la revendication 1, dans lequel au moins une diode à semi-conducteurs (104) du premier circuit de commutation à diodes (100, 100A à 100H) est couplée en série avec la première ligne de transmission quart d'onde (114, 114A à 114H) et la deuxième ligne de transmission quart d'onde (116, 116A à 116H).

6. Commutateur à diodes selon la revendication 1, dans lequel au moins une diode à semi-conducteurs (106A) du deuxième circuit de commutation à diodes (102, 102A à 102H) est couplée en série avec la première ligne de transmission quart d'onde (114, 114A à 114H) et la deuxième ligne de transmission quart d'onde (116, 116A à 116H), et une cathode d'au moins une diode à semi-conducteurs différente (106B) du deuxième circuit de commutation à diodes (102, 102A à 102H) a un couplage associé à la masse et une anode de ladite au moins une diode différente (106B) du deuxième circuit de commutation à diodes (102, 102A à 102H) a un couplage associé à une extrémité de la deuxième ligne de transmission quart d'onde (116, 116A à 116H) du côté pôle de direction (110, 110A à 110H) .

7. Procédé de commutation pour un commutateur à diodes à semi-conducteurs, dans lequel le commutateur comprend un pôle commun (108), au moins deux pôles de direction (110, 110A à 110H) et des trajets de signaux (112, 112A à 112H), dans lequel chacun des trajets de signaux (112, 112A à 112H) est entre le pôle commun (108) et l'un desdits au moins deux pôles de direction (110, 110A à 110H), et une première ligne de transmission quart d'onde (114, 114A à 114H) est entre le pôle commun (108) et le premier circuit de commutation à diodes (100, 100A à 100H), le premier circuit de commutation à diodes (100A à 100H) est couplé au trajet (112, 112A à 112H) entre la première ligne de transmission quart d'onde (114, 114A à 114H) et une deuxième ligne de transmission quart d'onde (116, 116A à 116H) ; et qui comprend :
l'activation (500), par une première branche de commande (1200) avec une première résistance de commande (1180) couplée au trajet (112, 112A à 112H) entre les première et deuxième lignes de transmission quart d'onde (114, 114A à 114H ; 116, 116A à 116H), d'un transfert de signal à travers au moins un trajet de signal (112, 112A à 112H) parmi les trajets de signaux (112, 112A à 112H) en commutant un premier circuit de commutation à diodes (100, 100A à 100H) et un deuxième circuit de commutation à diodes (102, 102A à 102H) entre lesquels il y a la deuxième ligne de transmission quart d'onde (116, 116A à 116H) vers un mode actif en faisant passer, à partir d'un commutateur de commande (250), une commande d'activation par l'intermédiaire de la première branche de commande (1200) qui a la première résistance de commande (1180) vers le premier commutateur à diodes (100, 100A à 100H), et en faisant passer, à partir du commutateur de commande (250), la commande d'activation vers le deuxième commutateur à diodes (102, 102A à 102H) ;
la désactivation (502) d'un transfert de signal à travers un trajet de signal (112, 112A à 112H) en commutant le premier circuit de commutation à diodes (100, 100A à 100H) et le deuxième circuit de commutation à diodes (102, 102A à 102H) vers un mode inactif, où une résistance de terminaison (118) est entre le deuxième circuit de commutation à diodes (102, 102A à 102H) et la masse, ou le deuxième circuit de commutation à diodes (102, 102A à 102H) est entre la résistance de terminaison (118) et la masse dans une deuxième branche de commande (1202) pour terminer le trajet de signal (112, 112A à 112H) en faisant passer, à partir d'un commutateur de commande (250), une commande de désactivation par l'intermédiaire de la branche de commande (1200) qui a la résistance de commande (1180) vers le premier commutateur à diodes (100A à 100H), et en faisant passer, à partir du commutateur de commande (250), la commande de désactivation vers le deuxième commutateur à diodes (102, 102A à 102H) ; et
l'équilibrage (504) d'une impédance de la première branche de commande (1200) pour qu'elle soit au moins à peu près égale à une impédance de la deuxième branche de commande (1202) avec la première résistance de commande (1180).

8. Procédé selon la revendication 7, dans lequel, avec chaque trajet de signal (112, 112A à 112H), la deuxième branche de commande (1202) a une deuxième résistance de commande (1182) ; et la valeur d'impédance de la première résistance de commande (1180) est au moins à peu près égale à une somme d'une impédance de la deuxième résistance de commande (1182) et d'une impédance de la résistance de terminaison (118).

9. Procédé selon la revendication 7, dans lequel le procédé comprend en outre l'activation du transfert de signal par la polarisation en inverse d'au moins une diode à semi-conducteurs (104) du premier circuit de commutation à diodes (100, 100A à 100H) et la désactivation du transfert de signal par la polarisation en direct d'au moins une diode à semi-conducteurs (104) du premier circuit de commutation à diodes (100, 100A à 100H), dans lequel une cathode de ladite au moins une diode à semi-conducteurs (104) du premier circuit de commutation à diodes (100, 100A à 100H) est couplée à la masse et une anode de ladite au moins une diode (104) du premier circuit de commutation à diodes (100, 100A à 100H) est couplée à la première ligne de transmission quart d'onde (114, 114A à 114B).

10. Procédé selon la revendication 7 ou 9, dans lequel une cathode d'au moins une diode à semi-conducteurs (106, 106A, 106B) du deuxième circuit de commutation à diodes (102, 102A à 102H) a un couplage associé à la masse et une anode de ladite au moins une diode (106) du deuxième circuit de commutation à diodes (102, 102A à 102H) a un couplage associé à une extrémité de la deuxième ligne de transmission quart d'onde (116, 116A à 116H) du côté pôle de direction (110, 110A à 110H).

11. Procédé selon la revendication 7, dans lequel le procédé comprend en outre l'activation du transfert de signal par la polarisation en direct d'au moins une diode à semi-conducteurs (104) du premier circuit de commutation à diodes (100, 100A à 100H), dans lequel au moins une diode à semi-conducteurs (104) du premier circuit de commutation à diodes (100, 100A à 100H) est couplée en série avec la première ligne de transmission quart d'onde (114, 114A à 114H) et la deuxième ligne de transmission quart d'onde (116, 116A à 116H).

12. Procédé selon la revendication 7, dans lequel une cathode d'au moins une diode à semi-conducteurs (106) du deuxième circuit de commutation à diodes (102, 102A à 102H) a un couplage associé à la masse et une anode de ladite au moins une diode (106) du deuxième circuit de commutation à diodes (102, 102A à 102H) a un couplage associé à une extrémité de la deuxième ligne de transmission quart d'onde (116, 116A à 116H) du côté pôle de direction (110, 110A à 110H).

13. Procédé selon la revendication 7, dans lequel le procédé comprend en outre l'activation du transfert de signal par la polarisation en direct d'au moins une diode à semi-conducteurs (106A) du deuxième circuit de commutation à diodes (102, 102A à 102H) et par la polarisation en inverse d'au moins une diode à semi-conducteurs différente (106B) du deuxième circuit de commutation à diodes (102, 102A à 102H), et la désactivation du transfert de signal par la polarisation en inverse d'au moins une diode à semi-conducteurs (106A) du deuxième circuit de commutation à diodes (102, 102A à 102H) et la polarisation en direct de ladite au moins une diode à semi-conducteurs différente (106B) du deuxième circuit de commutation à diodes (102, 102A à 102H), dans lequel
au moins une diode à semi-conducteurs (106A) du deuxième circuit de commutation à diodes (102, 102A à 102H) est couplée en série avec la première ligne de transmission quart d'onde (114, 114A à 114H) et la deuxième ligne de transmission quart d'onde (116, 116A à 116H), et une cathode d'au moins une diode à semi-conducteurs différente (106B) du deuxième circuit de commutation à diodes (102, 102A à 102H) a un couplage associé à la masse et une anode de ladite au moins une diode différente (106B) du deuxième circuit de commutation à diodes (102, 102A à 102H) a un couplage associé à une extrémité de la deuxième ligne de transmission quart d'onde (116, 116A à 116H) du côté pôle de direction (110, 110A à 110H).
